# EUROPEAN PATENT SPECIFICATION

(11) **EP 1 566 850 B1**
(45) Date of publication and mention of the grant of the patent: **13.01.2010**
(21) Application number: 05003702.7
(22) Date of filing: 21.02.2005
(51) Int. Cl.: H01L 39/24

(54) **Oxide superconductor thick film and method for manufacturing same**
Oxidsupraleiter-Dickschicht und Verfahren zu deren Herstellung
Couche épaisse en oxyde supraconducteur et méthode de sa fabrication

(30) Priority: 20.02.2004 EP 04003876
(43) Date of publication of application: 24.08.2005
(73) Proprietor: DOWA Electronics Materials Co., Ltd., Chiyoda-ku Tokyo 101-0021 (JP); Central Research Institute of Electric Power Industry, Yokosuka-shi, Kanagawa 240-0196 (JP)
(72) Inventor: Kojima, Masahiro, Chiyoda-ku Tokyo 100-8282 (JP); Kawahara, Masakazu, Chiyoda-ku Tokyo 100-8282 (JP); Ichikawa, Michiharu c/o Central Research Institute, Yokosuka-shi Kanagawa 240-0196 (JP); Kado, Hiroyuki c/o Central Research Institute, Yokosuka-shi Kanagawa 240-0196 (JP); Shibuya, Masatoyo c/o Central Research Institute, Yokosuka-shi Kanagawa 240-0196 (JP)
(74) Representative: Grünecker, Kinkeldey, Stockmair & Schwanhäusser Anwaltssozietät

(56) References cited:
- WO-A-92/13649
- DE-U- 20 315 783
- US-A1- 2004 110 641
- SINH N H: "Properties of the Bi-surplus superconducting Bi2.1-xPbxSr2Ca2Cu3Oy compounds" JOURNAL OF MAGNETISM AND MAGNETIC MATERIALS, vol. 262, no. 3, June 2003 (2003-06), pages 514-519, XP004429226 ISSN: 0304-8853
- PATENT ABSTRACTS OF JAPAN vol. 1995, no. 02, 31 March 1995 (1995-03-31) -& JP 06 318412 A (SUMITOMO HEAVY IND LTD), 15 November 1994 (1994-11-15)
- PATENT ABSTRACTS OF JAPAN vol. 014, no. 480 (C-0771), 19 October 1990 (1990-10-19) -& JP 02 199023 A (SUMITOMO HEAVY IND LTD), 7 August 1990 (1990-08-07)

## Description

The present invention relates to an oxide superconductor thick film comprising Bi, Pb, Sr, Ca and Cu with good adhesion to a substrate or a base body, having a high critical current density, and the method of manufacture thereof.

Various application products have been designed by forming and functioning an oxide superconductor in a thick film formed over an oxide substrate or an oxide base body such as MgO, alumina, and YSZ, and a metal substrate or a metal base body such as Ag, Au, Pt, and Ni.

A method of forming the oxide superconductor thick film includes a technique to form a polycrystalline oxide superconductor thick film by adding a proper organic binder to oxide superconductor powder to make it to be paste-shape, and thereafter applying the paste onto the substrate or the base body by using a screen printing method, a doctor blade method, or a spray method, which is then subjected to firing.

The technique to form the oxide superconductor thick film does not require an expensive single crystal substrate and a large scale, expensive device requiring a high vacuum system such as PVD and CVD and so forth. This contributes to drastically reducing a cost advantageously to the manufacture, and such a technique is considered to come in practice shortly.

When considering that the oxide superconductor thick film is put to practical use, it is promising to use the thick film (described as Bi2223-type thick film) containing (Bi,Pb)₂₊ₐSr₂Ca₂Cu₃O_{z} (generally 0<a<0.5) as the oxide superconductor thick film material, from two viewpoints of required superconductivity and a manufacturing cost including a manufacturing step from a raw material.

The method of forming such a Bi2223 type thick film is described below.

First, a Bi type superconducting paste is applied on an oxide substrate as a coating material such as MgO, alumina or YSZ by a screen printing method, a doctor blade method or a spray method. The oxide superconducting powder within the Bi type superconducting paste which has been applied on the above substrate contains as a principal phase a (Bi,Pb)₂Sr₂Ca₁Cu₂O_{z} phase having a critical temperature of Tc to about 80K (referred to as Bi2212 phase below) instead of a (Bi,Pb)₂₊ₐSr₂Ca₂Cu₃O_{z} phase having a critical temperature of Tc to about 110K (referred to as Bi2223 phase below), and is also a composite phase comprising intermediate formation phases such as Ca₂PbO₄, CaCuO₂ and CuO.

When the Bi type superconducting paste applied on the above substrate is subjected to heat treatment, reaction such as (Bi,Pb)₂Sr₂Ca₁Cu₂O_{z} + intermediate formation phase → (Bi,Pb)₂₊ₐSr₂Ca₂Cu₃O_{z} occurs to form a Bi2223 phase from a Bi2212 phase and an intermediate forming phase. As a result, the oxide superconducting thick film comprising the Bi2223 phase having a high critical temperature is formed on the oxide superconducting thick film.

However, when the oxide superconducting thick film is put to practical use, not only a high critical temperature, but also a high critical current density (referred to as Jc hereafter) is required at the same time. Also, when the oxide superconducting thick film is put to practical use, not less than 5,000A/cm² of Jc is required.

Generally, in order to obtain not less than 5,000 A/cm² of Jc using the above-mentioned thick film comprising a Bi2223 phase (referred to as Bi2223 thick film hereafter), plate crystals characteristic of Bi type oxide superconductors, which have large ab surfaces and are short in the direction of the c axis, are orientated so that the ab surfaces over which the superconducting current flows readily are lined up in direction of the current. A compression process such as CIP (cold hydrostatic pressure press) or HIP (hot isotropic pressure press) is used in order to line up the plate crystals in the direction of the current.

Even if the Jc of the Bi2223 thick film is increased by carrying out such a compression process, a sufficiently large net superconducting current value cannot be obtained if the essential cross section of the thick film through which the superconducting current flows is small, thus being unsuitable for practical use. Therefore, it needs to be so designed that a sufficient critical current value (Ic) can be obtained by securing a cross section of the Bi2223.

Based on the above, the following process is used when forming an oxide superconducting thick film having a high Jc value and a high critical current value on the substrate. (see Patent document 1 for example)
(1)Bi type oxide superconducting paste is applied on a suitably selected oxide substrate up to a prescribed thickness.
(2)The oxide substrate on which the Bi type oxide superconducting paste has been applied is subjected to primary firing.
(3)The oxide substrate following primary firing is placed within a CIP and compressed.
(4) The firing process of (2) and the compression process of (3) are carried out repeatedly over a suitable number of times. An oxide substrate coated with a Bi2223 thick film is obtained after the final firing.

Patent document 1 Japanese Patent Application No.2001-358298

A problem in the method of forming the Bi2223 thick film according to a conventional art is that the thick film is frequently stripped from the oxide substrate during film formation process, thus being low in yield and low in productivity. This strip-off frequently occurs at the time of firing or after CIP, and is particularly frequent between primary firing and primary CIP. Therefore, after study on the stripping of the thick film from the oxide substrate, the inventors of the present invention found as follows.

First, the reason for the stripping of the thick film at the time of firing is considered as follows:
(1) Difference in the coefficient of thermal expansion (coefficient of linear expansion) between the oxide substrate and the superconductor, and
(2) volumetric changes upon expansion of the entire thick film which accompanies crystal metamorphosis, where high Tc phases are formed from low Tc phases and intermediate forming phases. In particular, the factor of (2), which dominantly acts, is considered to be the main cause of the frequent stripping of the thick film at primary firing.
   Next, the reason for the stripping of the thick film after CIP is considered as follows:
(3) A specified hydrostatic pressure (0.5-3.0 tons/cm²) is applied to the thick film and the oxide substrate on which the thick film is formed. These are compressed. The residual stress built up within the thick film during compression is released. However, such a residual stress is considered be caused by the phenomenon that acts as a force that pulls the thick film away from the oxide substrate. This force is thought to be apparent when the oxide substrate has a cylindrical shape.

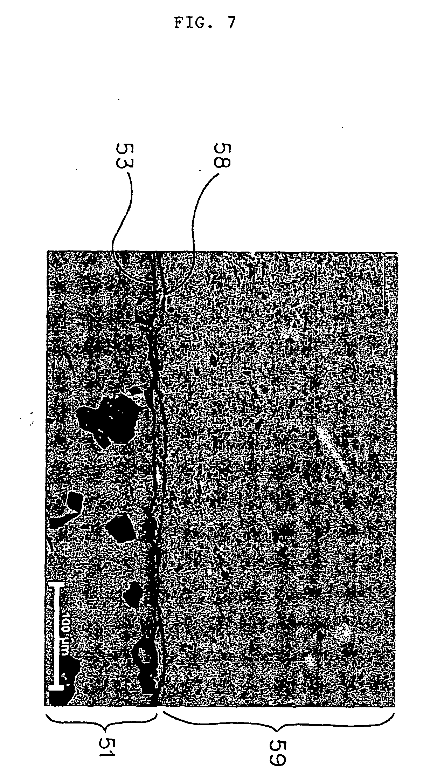

The inventors of the present invention carried out an analysis of Bi2223 thick film related to the prior art where the film was formed on the substrate. The results of the analysis are explained below with reference to Fig. 7.

Fig. 7 is an optical microphotography of a cross section of a Bi2223 thick film related to the prior art where the film is formed on an MgO substrate.

In Fig. 7, the designation mark 51 indicates the cross section of the MgO substrate, the designation mark 59 indicates a cross section of the Bi2223 thick film related to the prior art and the designation mark 53 indicates the interface of MgO substrate 51 and Bi2223 thick film 59. After detailed observation, it was found that a breakage surface 58 was developed in the region of approximately 2-10µm from the interface 3 of the Bi2223 thick film 59. The inventors of the present invention carried out further analyses of numerous Bi2223 thick films related to the prior art and found that breakage surfaces occurred in the oxide superconductor thick film, not only in cases where the oxide superconductor thick film is stripped from the oxide substrate during the manufacturing process, but also in cases which did not result in strip-off.

When this breakage surface is relatively large, the oxide superconductor thick film is stripped from the oxide substrate at firing and after CIP compression during the manufacturing process. A small breakage surface does not result in stripping of the oxide superconductor thick film from the oxide substrate during the manufacturing process.

However, the breakage surface grows every time thermal and mechanical impact is applied to the substrate and the oxide superconductor thick film, resulting in the stripping of the oxide superconductor thick film in the end.

US-A-2004/0110641 and DE-U-20315783 independently disclose an oxide superconductor thick film and a method for manufacturing the same, wherein said oxide superconductor thick film is prepared by forming a first thick film having the composition of Bi₂Sr₂Ca₁ Cu₂O_{z} on the surface of a substrate, and thereafter forming an oxide superconductor thick film having the composition of (Bi,Pb)₂₊ₐSr₂Ca₂Cu₃O_{Z} on said first thick film, wherein 0<a<0.5.

Based on the above study results, the object of the present invention is to provide a B12223 thick film which is not stripped from the oxide substrate even if the thermal and mechanical impact is applied to the substrate and the oxide superconductor thick film during the manufacturing profess, and a method of manufacture thereof.

Said object is achieved by an oxide superconductor thick film and a method for manufacturing the same, wherein said oxide superconductor thick film is obtainable by the method of forming an oxide superconductor thick film comprising Bi, Pb, Sr, Ca, and Cu on the surface of a substrate or a base body, wherein, after forming a primary thick film (4) substantially having the composition expressed by Bi₂Sr₂Ca₁Cu₂O_{z} on the surface of said substrate or base body (3), an oxide superconductor thick film (5) substantially having the composition expressed by (Bi,Pb)₂₊ₐSr₂Ca₂Cu₃O_{z} satisfying 0<a<0.5 is formed on said primary thick film, wherein the composition formula of a superconducting composite powder contained in the coating material (2) used for the formation of the oxide superconductor thick film is (Bi,Pb)₂₊ₐSr₂Ca₂Cu₃O_{z} satisfying 0<a<0.5 and 0.35<Pb<0.60, and wherein a breakage surface does not exist in said oxide superconductor thick film near the interface of said substrate and said oxide superconductor thick film.

"Z" is a fluctuant according to the manufacturing conditions, especially oxygen partial pressure during a burning of oxide superconductor raw materials. As shown in this application, because the oxide superconductor raw material is burned in the atmosphere, "Z" is about 10. The above matter is common knowledge in the industry dealing with oxide superconductors.

The presence of the breakage surface can be confirmed by, for example, using a diamond cutter to cut the substrate on which the oxide superconductor thick film is formed at random locations to expose a cross section of the substrate section and the thick film section. These cross sections are then observed by an optical microscope. Usually, if the breakage surface is not present in these sections, it may be said that the entire oxide superconductor thick film is free of the breakage surface. In a Bi2223 thick film having the above composition, since the breakage surface does not exist over the entire said thick film, the stripping of the thick film from the substrate upon heating and cooling, compression and mechanical impact to the substrate and the oxide superconductor thick film during or after the manufacturing process can be avoided.

According to the method of manufacturing a Bi2223 thick film having the aforementioned structure, the Bi2223 thick film free of the breakage surface in the thick film can be easily formed.

By forming the oxide superconductor thick film having substantially the composition formula expressed by (Bi,Pb)₂₊ₐSr₂Ca₂Cu₃O_{z} where 0<a<0.5 on the first thick film, the oxide superconductor thick film having a large critical current value Ic can be obtained.
Fig. 1 is a process flow chart showing the formation of an oxide superconductor thick film related to the present invention;
Fig. 2 is a process flow chart showing an example of a manufacturing process of an oxide superconducting paste related to the present invention;
Fig. 3 is a light microscope photograph of a cross section of an oxide superconductor thick film related to the present invention;
Fig. 4 is a light microscope photograph of a different cross section of an oxide superconductor thick film related to the present invention;
Fig. 5 shows analysis results obtained by EPMA of an oxide superconductor thick film related to the present invention;
Fig. 6 shows analysis results obtained by XRD of an oxide superconductor thick film related to the present invention;
Fig. 7 is a light microscope photograph of a cross section of an oxide superconductor thick film related to the prior art; and
Fig. 8 is a graph showing the amount of Pb in an oxide superconductor thick film material related to the present invention and the Ic values of the said thick film sample.

The embodiments of the present invention are described in detail below with reference to the figures.

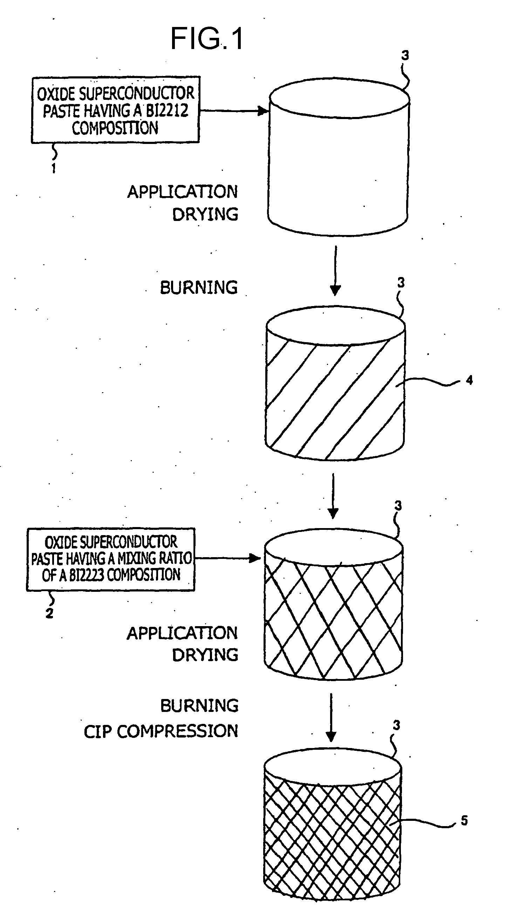

Fig. 1 is the process of forming an oxide superconductor thick film related to the present invention on the substrate, and shows a flow chart using as an example an MgO cylindrical substrate as the above substrate. First, the manufacturing process of an oxide superconductor thick film related to the embodiment of the present invention is described with reference to Fig. 1.

For example, a substrate 3 made of ceramic (below as substrate) is prepared. An oxide superconducting paste 1 (below as Bi2212 paste) is applied as a coating material having a compounding ratio of Bi2212 composition to the above substrate 3 and dried. (The preferable method of manufacturing said Bi2212 paste 1 is described below). Following completion of drying, the substrate 3 to which the Bi2212 paste 1 has been applied is heated for 10-30 minutes at 880-885°C under atmospheric conditions, and the Bi2212 paste 1 is fired at a temperature close to the melting point [of the above substrate]. The Bi2212 paste fired at a temperature close to the melting point then partially assumes a fusion state. This results in the formation of a Bi2212 partial fusion layer 4, or a primary thick film substantially having the composition of Bi₂Sr₂Ca₁Cu₂O_{z} on the substrate 3.

Next, an oxide superconducting paste having a compounding ratio of Bi2223 composition (below as Bi2223 paste) 2 is applied to the substrate 3 to which the Bi2212 partial fusion layer 4 is formed and dried. (The preferable method of manufacturing said Bi2223 paste 2 is described below). Following completion of drying, the substrate 3 to which the Bi2223 paste 2 has been applied is heated for 50-100hr at 830-860°C under atmospheric conditions, and the Bi2223 paste 2 is fired. The substrate 3 with the fired Bi2223 paste 2 is then compressed at a pressure of 2-3t/cm² using a CIP device (cold hydrostatic pressure press). This is followed by a specified number of burns and compressions. The substrate 3 to which a Bi2223 thick film 5 is formed is then obtained following the final burn.

Next, as mentioned above, the course of obtaining the desired substrate 3 on which the oxide superconductor thick film 5 is formed is described in detail by process.

First, cylindrical and tabular substrates formed from ceramic material such as MgO, alumina or YSZ or metallic material such as Ag, Au, Pt or Ni can be used as the substrate 3. The suitability, material, shape and size may be selected according to the final objective of manufacture. However, MgO is the preferred material for the substrate 3 in terms of its low reactivity and adhesiveness (bonding strength) with Bi2212.

Methods such as brush coating, immersion and spray application can be used when applying the Bi2212 paste 1 to the substrate 3. However, the spray application method is the preferred method of application in terms of productively applying the [paste] over a large area.

The film thickness when applying the Bi2212 paste 1 to the substrate 3 should preferably be 10-100µm. A film thickness of 10µm or above is preferable since it results in an even bonding strength as mentioned below without giving rise to sectional coating surface irregularities. A film thickness of 100µm or below is preferable since this insures that the Bi2212 film reacts sufficiently with the Bi2223 paste during the process as mentioned below.

Once the Bi2212 paste 1 has been applied to the substrate 3, the [substrate] is sufficiently dried, heated at 880-885°C under atmospheric conditions, fired for 10-30 minutes and returned to room temperature. Since this temperature is extremely close to the atmospheric melting point of Bi2212, part of the Bi2212 film that has been applied undergoes fusion, resulting in the formation of a Bi2212 partial fusion layer 4 on the substrate 3. The film thickness of this Bi2212 partial fusion layer 4 is approximately 40µm.

Next, Bi2223 paste 2 is further applied as a coating material to the Bi2212 partial fusion layer 4 that has been formed on the substrate 3. The method of application is the same as that for the above-mentioned Bi2212 paste 1. The film thickness at the time of application should preferably be as thick as possible, and should preferably be 200µm or more.

The Bi2223 paste 2 is applied to the Bi2212 partial fusion layer 4. [The paste] is sufficiently dried and heated to 830-860°C, or more preferably to 835-850°C under atmospheric conditions. This is then fired for 50-100 hours and returned to room temperature. The entire [layer and paste] is then placed inside a CIP device and compressed under a pressure of 2-3 tons/cm². As a result of this compression, the density of the (Bi,Pb)₂₊ₐSr₂Ca₂Cu₃O_{z} plate crystal of less than 3 which is formed when firing increases to 4 or more. The Jc also increases from several hundred A/cm² to 5000 A/cm² since the plate crystals arrange the ab surfaces in line in the direction of current to allow a smoother flow of superconducting current.

Once compression is complete, the entire [layer and paste] is taken out of the CIP device and once more heated at 830-860°C, or more preferably at 835-850°C under atmospheric conditions. This is maintained for 50-100 hours and fired before being returned to room temperature to obtain a Bi2223 sintering film 5 which is formed on the substrate 3. This Bi2223 sintering film 5 obtained by the above process was not stripped from the substrate 3.

An observation of the structure of the Bi2223 sintering film, which is not stripped from the substrate 3, was carried out. The results of this observation are described with reference to the figures.

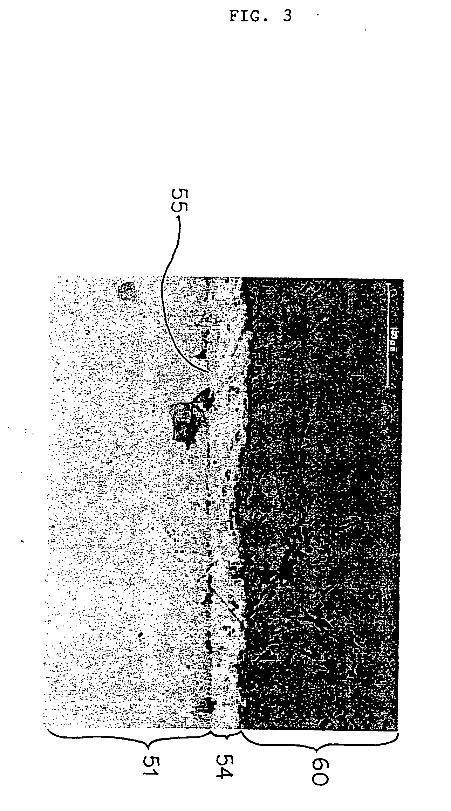

Fig. 3 is a light microscope photograph of a structural cross section of a Bi2212 partial fusion layer 54 which is formed on an MgO substrate 51 via an interface 55 as shown by the symbol 4 of Fig. 1.

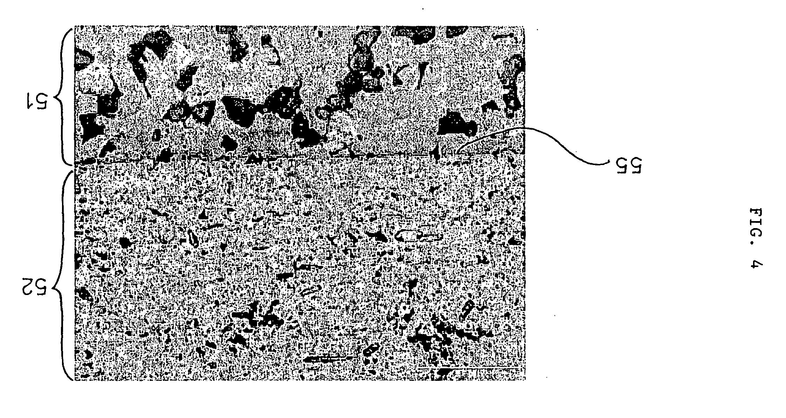

Fig. 4 is a light microscope photograph of a structural cross section of a Bi2223 sintering film 52 which is formed on the substrate 51 via the interface 55 and the Bi2212 partial fusion layer 54 as shown by the symbol 5 of Fig. 1.

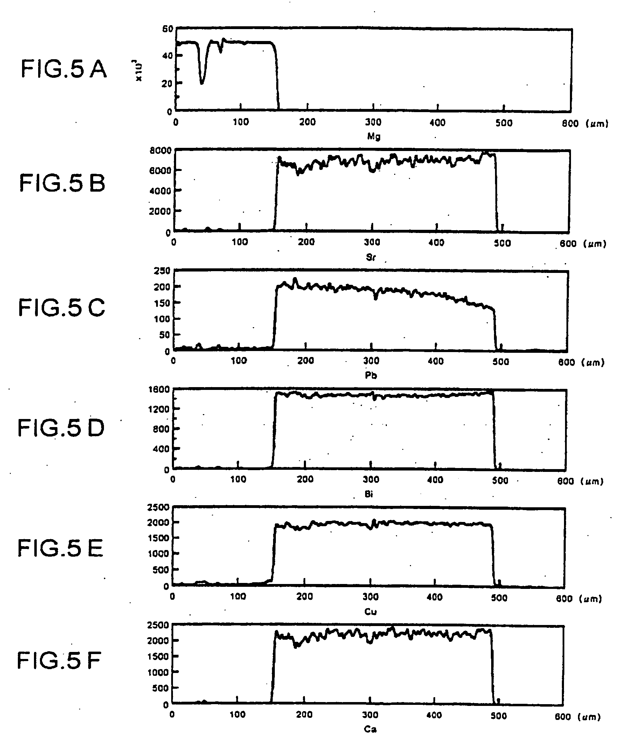

Fig. 5 are the results of a linear analysis of respective constituent elements in the direction of film thickness from the surface of the Bi2223 sintering film as shown in Fig. 4 to the substrate using EPMA.

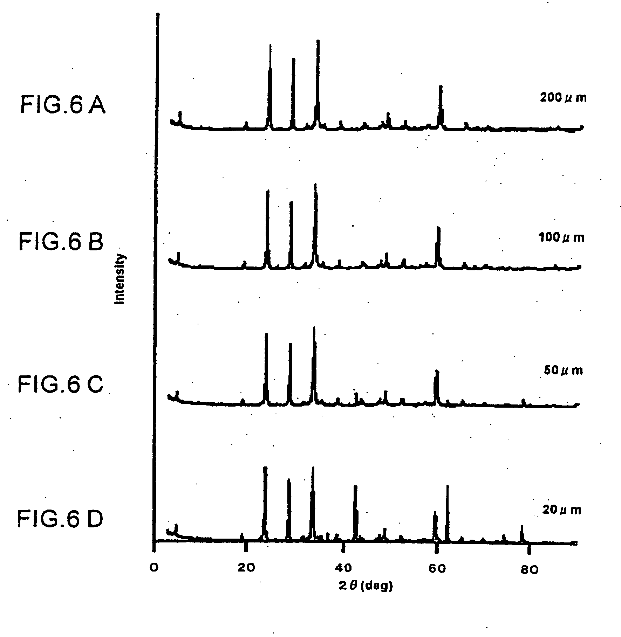

Fig. 6 are charts showing X-ray diffraction measurement results for respective locations from the surface of the Bi2223 sintering film as shown in Fig. 4 to the substrate.

In Fig. 3, a look at the Bi2212 partial fusion layer 54 shows that the Bi2212 crystal particles undergo partial fusion since the firing temperature is extremely close to the atmospheric melting point of Bi2212. The pores between the crystal particles are filled in, resulting in stronger bonds between the particles. This results in the formation of a fine film. It also shows that the Bi2212 partial fusion layer 54 fits tightly into the fine spaces and irregularities of the MgO substrate 51 surface at the interface 55 of the Bi2212 partial fusion layer 54 and the MgO substrate 51.

Furthermore, when the Bi2212 layer undergoes partial fusion, an interdiffusion of elements is considered to take place between the melted liquid phase component and the MgO substrate 51 at the interface of the Bi2212 partial fusion layer 54 and the MgO substrate 51. This is thought to result in extremely strong adherence, both structurally and chemically, between the Bi2212 partial fusion layer 54 and the MgO substrate 51. (The section shown by symbol 60 above the Bi2212 partial fusion layer 54 is an epoxy resin for said light microscope sample preparation).

Fig. 4 does not show a clear Bi2212 partial fusion layer as described in Fig. 3, where the Bi2223 sintering film 52 seems to be formed on the MgO substrate 51 via the interface 55.

An analysis of the structure of the layer/film of this section was carried out in greater detail.

According to the Mg analysis results as shown in Fig. 5(a), an interface was present approximately 150µm from the reference point (the point where the position of the horizontal axis is zero) on the chart. Here, Mg decreases acutely. This is considered to be due to the Mg which makes up the substrate undergoing elemental diffusion.

Next, as shown in Fig. 5(b)-(f), the thickness of the film as shown by the symbol 52 in Fig. 4 was approximately 350µm based on analysis results of the respective elements Sr, Pb, Bi, Cu and Ca. The film thickness, including the Bi2212 partial fusion layer, at the time of Bi2223 film application drying was 640µm. This was seen to decrease to approximately 350µm following firing and compression.

Furthermore, based on Fig. 5(b)-(f), a study was carried out concerning the analysis results of the respective elements Sr, Pb, Bi, Cu and Ca.

With the exception of Pb, Sr, Bi, Cu and Ca were seen to be present at an almost even concentration within the film. Originally, the composition ratios of Ca and Cu were different in Bi2212 and Bi2223. This meant that, for corresponding elemental linear analyses, there had to be a corresponding change in strength on either side of the boundary between the Bi2212 partial fusion layer and the Bi2223 film. However, results for both Ca and Cu showed almost no change in strength, where the concentration of Ca and Cu was almost even throughout the entire thick film.

Fig. 5(c) shows that Pb concentration within the thick film gradually decreased from the interface with the substrate in the direction of the film surface. This decrease in the Pb concentration is considered to be due to the external dispersion of Pb as it gets closer to the film surface upon firing the Bi2223.

On the other hand, there was almost no decrease in the concentration of Pb within the thick film to the interface with the substrate. Given that the initial Bi2212 partial fusion layer at the time of formation did not contain Pb, it is considered that the Pb diffused into the original Bi2212 partial fusion layer section.

Next, based on the analysis results of Fig. 6, starting at a position 20µm from the substrate that formed the Bi2212 partial fusion layer, the Bi2212 peak could not be detected prior to firing based on thick film XRD at the 20-200µm position, where all showed Bi2223 diffraction peaks.

Based on the above, it is considered that the respective elements Pb, Ca and Cu diffused into the Bi2212 partial fusion layer from the Bi2223 film formed on the Bi2212 partial fusion layer by means of firing to yield an even composition throughout the entire film. In addition, it is thought that, in crystalline terms, the Bi2212 partial fusion layer practically changed into Bi2223.

A study was carried out concerning the significance of the Bi2212 partial fusion layer practically changing into Bi2223.

Firstly, as mentioned above, the Bi2212 partial fusion layer was strongly bonded with the substrate at the boundary with the substrate. This state of adherence at the boundary with the substrate is considered to be preserved even if the Bi2212 partial fusion layer practically changes into Bi2223, where the strong bond is also maintained.

Secondly, the entire thick film expands along with a volumetric expansion upon firing of Bi2223 paste and formation of Bi2223, which is considered to alleviate the stripping of the thick film from the substrate. In other words, when Bi2223 paste is applied directly to a substrate such as an MgO substrate, and where a volumetric expansion occurs which accompanies the formation of Bi2223 from the above paste, the Bi2223 formed is stripped from the substrate. However, if a Bi2212 partial fusion layer exists between the substrate and the Bi2223 paste, the Bi2212 partial fusion layer not only maintains a strong bond with the substrate, but also incorporates the Pb, Ca and Cu supplied by the Bi2223 component paste layer that causes crystalline formation, gradually changing into Bi2223. As with a gradient material, this results in a continuous change in the film crystalline structure, which is thought to cushion the expansion at the boundary with the substrate, thereby controlling the stripping of the thick film from the substrate.

The inventors of the present invention found that, in addition to the above-mentioned effects, the critical current value Ic of the superconducting thick film obtained could be increased by using a superconducting composite powder satisfying 0<a<0.5, 0.35<Pb<0.60 when the composition formula of the superconducting composite powder contained in the Bi2223 paste, or the coating material, is expressed as (Bi, Pb)₂₊ₐSr₂Ca₂Cu₃O_{z}.

The reason is that by setting the amount of Pb in the superconducting composite powder within the Bi2223 paste at 0<a<0.5, 0.35<Pb<0.60, the Pb component undergoes external dispersion or diffusion into the adjoining Bi2212 partial fusion layer section when sintering the Bi2223 paste. Thus, even if there is a decrease in the Pb content of the Bi2223 crystals, this decrease in the Pb content does not lead to the decomposition or heterogeneous formation of the said crystals.

In other words, the amount of Pb contained in Bi2223 crystals following the sintering of Bi2223 paste is considered to be significantly lower than the amount of Pb contained in the initial Bi2223 paste. This diffusion of Pb from within the crystals results in an unstable Bi2223 crystal, causing the decomposition or heterogeneous formation of crystals. This is considered to lead to the deterioration of superconducting properties such as the critical current density Ic. In order to prevent the decomposition or heterogeneous formation of Bi2223 crystals, the above-mentioned amount of Pb is made to have the composition satisfying 0<a<0.5, 0.35<Pb to insure that a sufficient amount of Pb remains within the Bi2223 component even after the dispersion or diffusion of Pb that occurs by firing. Meanwhile, when the Pb amount is in the range of 0.60>Pb, the problem can be averted, which is caused by the Pb amount remained in the Bi2223 crystal being excessive even after the dispersion or diffusion of Pb that occurs by firing, resulting in a different phase formation conversely, and the different phase thus formed inhibiting an effective superconducting current path, to apply an adverse effect on the superconducting property.

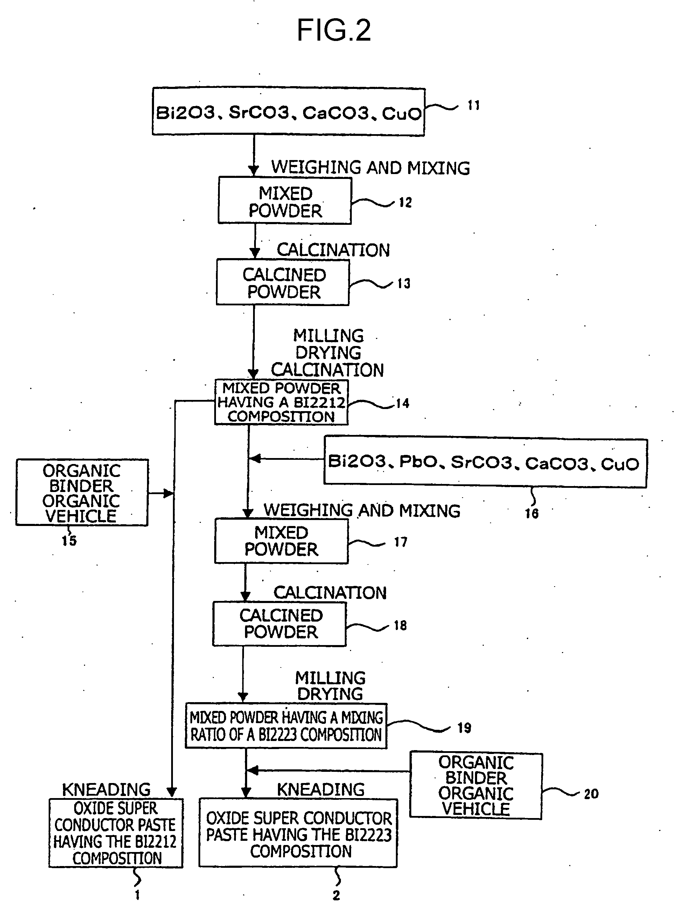

The methods of manufacturing Bi2212 paste 1 and Bi2223 paste 2 as used in the present embodiment are described with reference to Fig. 2, which is a flow chart showing an example of the manufacturing process of oxide superconducting paste.

In Fig. 2, various powders 11 of Bi₂O₃, SrCO₃, CaCO₃ and CuO are weighed and mixed so that the whole has a Bi2212 molar ratio to form a mixed powder 12. Here, the CaCO₃ may be substituted by CaO or Ca(OH)₂. In addition to the above mixture of powder, the mixed powder 12 may also be obtained by preparing a desired molar ratio from the respective elements Bi, Sr, Ca and Cu by means of a wet coprecipitation process.

Next, the mixed powder 12 is subjected to calcination to prepare a calcined powder 13. Calcination should be carried out under atmospheric conditions at a temperature of 600°C-1000°C, or preferably 750°C-850°C, for a period of 3 to 50 hours. The calcined powder 13 obtained is placed in a ceramic pot along with organic solvents such as Zr bole and toluene. This is then fixed onto a rotating table and bole milling is carried out. The object of this operation is to both improve evenness by finely crushing the calcined powder 13 and raise the thermal reactivity in the subsequent burn. The calcined powder 13 in the form of a slurry following completion of milling is dried in a dryer. These calcined powders are again subjected to calcination under the same conditions. Following this calcination, bole milling and firing is again carried out to obtain a composite powder having a Bi2212 composition 14. The composite powder having a Bi2212 composition 14 is then divided into 2 parts.

A suitable organic binder and an organic vehicle 15 is mixed with one part of the composite powder having a Bi2212 composition 14 which has been divided into 2 parts. An oxide superconducting paste 1 having a compounding ratio of Bi2212 composition is obtained by kneading using a 3-point roller.

Various powders 16 of Bi₂O₃, PbO, SrCO₃, CaCO₃ and CuO are added to the other part of the composite powder having a Bi2212 composition 14 which has been divided into 2 parts. This is weighed and mixed so that the whole has a Bi2223 molar ratio to form a mixed powder 17. Here, the CaCO₃ may be substituted by CaO or Ca(OH)₂. In addition to the above mixture of powder, the mixed powder 12 may also be obtained by preparing a desired molar ratio from the respective elements Bi, Sr, Ca and Cu by means of a wet coprecipitation process. Material may also be used wherein the respective elements Bi, Sr, Ca and Cu have been prepared to have the desired molar ratio by means of a wet coprecipitation process.

Next, the mixed powder 17 undergoes calcination to obtain a calcined powder having a compounding ratio of Bi2223 composition 18. Calcination should be carried out under atmospheric conditions at a temperature of 600°C-1000°C, or preferably 750°C-850°C, for a period of 3 to 50 hours. As a whole, the calcined powder having a compounding ratio of Bi2223 composition 18 which has been obtained is, including the Bi2212 phase and intermediate formation phases such as Ca₂PbO₄, CaCuO₂ and CuO, a powder having a compounding ratio of Bi2223 composition.

The calcined powder having a compounding ratio of Bi2223 composition 18 that has been obtained is placed in a ceramic pot along with organic solvents such as Zr bole and toluene. This is then fixed onto a rotating table and bole milling is carried out. The object of this operation is to both improve evenness by finely crushing the calcined powder and raise the thermal reactivity in the subsequent burn. The calcined powder having a compounding ratio of Bi2223 composition 18 in the form of a slurry following completion of milling is dried in a dryer, which again undergoes calcination. Following this calcination, bole milling and firing is again carried out to obtain a composite powder having a mixing ratio of Bi2223 composition 19.

Various powders 16 are added to the other part of the composite powder 14 to prepare the mixed powder 17. This mixed powder 17 is then subjected to calcination in order to obtain the calcined powder having a compounding ratio of Bi2223 composition 18. When this calcined powder is again subjected to calcination to obtain the composite powder having a mixing ratio of Bi2223 composition 19, the composition of the various powders 16 should be regulated so that the Bi and Pb molar ratio is 0<a<0.5, 0.35<Pb<0.60 when the composition formula of the composite powder 19 is expressed as (Bi,Pb)₂₊ₐSr₂Ca₂Cu₃O_{z}. The use of the said composition results in an increase in the critical current value Ic of the superconducting thick film obtained.

An oxide superconducting paste 2 having a compounding ratio of Bi2223 composition was obtained by mixing a suitable organic binder and organic vehicle 20 with the obtained composite powder having a Bi2223 composition 19, which was then kneaded using a 3-point roller.

The present invention is described below in concrete terms with reference to embodiments.

Embodiment 1: A cylindrical MgO polycrystal of outer diameter 50, inner diameter 40 and length 100mm was prepared as a substrate for the application of a superconducting thick film. A superconducting paste having a compounding ratio of Bi2212 composition was applied by spraying to the above-mentioned MgO substrate. This was then dried and fired under atmospheric conditions at a temperature of 880-885°C for 30 minutes. This temperature was extremely close to the atmospheric melting point of Bi2212, resulting in a partially melted Bi2212 partial fusion layer. The thickness of this Bi2212 partial fusion layer was approximately 40µm.

Next, a superconducting paste having a compounding ratio of Bi2223 composition was applied by spraying to the Bi2212 partial fusion layer formed on the above-mentioned MgO substrate and dried. The film thickness of the section of the superconducting paste having a compounding ratio of Bi2223 composition was 600µm. This was fired at a temperature of 850°C under atmospheric conditions for 50 hours.

Following completion of firing, the MgO substrate on which the oxide superconductor thick film is formed was placed inside a CIP device (cold hydrostatic pressure press) and was compressed at a pressure of 2-3tons/cm². This was then fired, CIP compressed and fired again to obtain a thick film sample.

The above process was carried out using 10 MgO substrates under the same conditions. Stripping of the thick film from the substrate was not detected in any of the samples.

Embodiment 2: 8 cylindrical MgO polycrystals of outer diameter 50, inner diameter 40 and length 100mm were prepared as substrates for the application of superconducting thick films. First, a superconducting paste having a compounding ratio of Bi2212 composition was applied by spraying to the above-mentioned MgO substrate. This was then dried and fired under atmospheric conditions at a temperature of 880-885°C for 30 minutes. This temperature was extremely close to the atmospheric melting point of Bi2212, resulting in a partially melted Bi2212 partial fusion layer. The thickness of this Bi2212 partial fusion layer was approximately 40µm.

Meanwhile, 8 types of X value were established between 0.35-0.70 at 0.05 intervals where the composition of the composite powder within the paste material having a compounding ratio of Bi2223 composition was expressed as Bi_{1.85}PbₓSr_{1.90}Ca_{2.05}Cu_{3.05}O_{z}. Superconducting paste samples having 8 types of Bi2223 composition having the said X values were then prepared.

The above-mentioned 8 types of superconducting paste having a compounding ratio of Bi2223 composition were respectively applied by spraying to the Bi2212 partial fusion layer formed on the above 8 MgO substrates. These were then dried.

The thickness of the section of superconducting paste having a compounding ratio of Bi2223 composition to be applied to the respective MgO substrates was 600µm. The respective MgO substrates to which the said superconducting paste was applied were then fired at a temperature of 850°C under atmospheric conditions for 50 hours.

Following completion of firing, the respective MgO substrates on which the oxide superconductor thick films are formed were placed inside a CIP device (cold hydrostatic pressure press) and were compressed at a pressure of 3tons/cm². These were again fired under the same conditions, CIP compressed under the same conditions and further fired for a 3^{rd} time to obtain thick film samples. The final thickness of the thick film samples obtained was approximately 300µm for all samples. Stripping of the said thick films from the substrate was not detected in any of the MgO substrates.

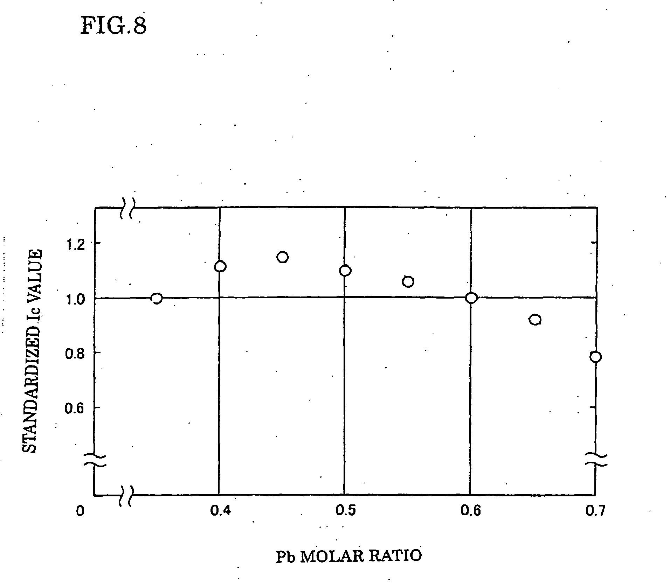

Strip samples measuring 20mm in the direction of height of the cylinder x 1mm in a horizontal direction were respectively cut from the said thick film samples on the 8 MgO substrates which were obtained. Using a silver paste, current terminals were established at each end of the strip samples and voltage terminals were established near the central area of the same. Next, the said samples were cooled to 77K using liquid nitrogen, and the critical current values Ic were measured by means of the 4-terminal method (electrization). Ic values for the 8 types of sample were normalized taking the Ic value obtained from a sample where X=0.35 as 1.0. This is shown in Fig. 8.

Fig. 8 is a graph where the vertical axis shows normalized Ic values and the horizontal axis shows the Pb molar ratio X values of the 8 types of sample.

The results in Fig. 8 show that the normal value of Ic was 1 or above over the range 0.35<X<0.60. This shows that, by using a paste of a Bi2223 composition having the composition formula (Bi,Pb)₂₊ₐSr₂Ca₂Cu₃O_{z} and which uses a composite powder satisfying O<a<0.5, 0.35<Pb<0.60, no stripping of the thick film from the substrate was detected. This enabled the critical current value Ic of the superconducting thick film obtained to be improved.

Comparative Example: An MgO substrate identical to that of the embodiments was prepared, to which an oxide superconducting paste having a compounding ratio of Bi2223 composition identical to that of the embodiments was applied by means of spraying. This was then dried. The thickness of the section of superconducting paste having a compounding ratio of Bi2223 composition was 600µm. This was then fired at a temperature of 850°C under atmospheric conditions for 50 hours.

In total, 10 MgO substrates were prepared, which were coated and fired under the same conditions. The thick film stripped-off in 5 of the substrates. CIP compression was carried out for the remaining 5 MgO substrates on which oxide superconductor thick films were formed as in the embodiments. Of these, 4 is stripped off. Only 1 sample completed the final process of CIP compression, firing, CIP compression, firing as in the embodiments.

As mentioned above, the present invention is an oxide superconductor thick film wherein an oxide superconductor thick film comprising Bi, Pb, Sr, Ca and Cu substantially having the composition of (Bi,Pb)_{2,a}Sr₂Ca₂Cu₃O_{z} where 0<a<0.5 is formed on the surface of a substrate and wherein a breakage surface does not exist within the above oxide superconductor thick film near the interface of the above substrate and the above oxide superconductor thick film. Furthermore, stripping of a Bi2223 thick film having the above composition from the substrate upon heating/cooling, compression or mechanical impact to the substrate and oxide superconductor thick film during or following the manufacturing process can be avoided.

## Claims

1. An oxide superconductor thick film obtainable by forming an oxide superconductor thick film comprising Bi, Pb, Sr, Ca, and Cu on the surface of a substrate or a base body, wherein, after forming a primary thick film (4) substantially having the composition expressed by Bi₂Sr₂Ca,CU₂O_{z}, on the surface of said substrate or base body (3), an oxide superconductor thick film (5) substantially having the composition expressed by (Bi,Pb)₂₊ₐSr₂Ca₂Cu₃O_{z} satisfying 0<a<0.5 is formed on said primary thick film, wherein the composition formula of a superconducting composite powder contained in the coating material (2) used for the formation of the oxide superconductor thick film is (Bi,Pb)₂₊ₐSr₂Ca₂Cu₃O_{z}, satisfying 0<a<0.5 and 0.35<Pb<0.60, and wherein a breakage surface does not exist in said oxide superconductor thick film near the interface of said substrate and said oxide superconductor thick film.

2. A method of manufacturing an oxide superconductor thick film for forming an oxide superconductor thick film comprising Bi, Pb, Sr, Ca, and Cu on the surface of a substrate or a base body, wherein, after forming a primary thick film (4) substantially having the composition expressed by Bi₂Sr₂Ca₁Cu₂O_{z}, on the surface of said substrate or base body (3), an oxide superconductor thick film (5) substantially having the composition expressed by (Bi,Pb)₂₊ₐSr₂Ca₂Cu₃O_{z}, satisfying 0<a<0.5 is formed on said primary thick film, **characterised in that** the composition formula of a superconducting composite powder contained in the coating material (2) used for the formation of the oxide superconductor thick film is (Bi,Pb)₂₊ₐSr₂Ca₂Cu₃O_{z} satisfying 0<a<0.5 and 0.35<Pb<0.60.

## Patentansprüche

1. Oxidsupraleiter-Dickfilm erhältlich durch das Formen eines Oxidsupraleiter-Dickfilms, welcher Bi, Pb, Sr, Ca und Cu umfasst, auf der Oberfläche eines Substrates oder eines Basiskörpers, wobei, nach dem Formen eines primären Dickfilms (4), welcher im Wesentlichen die durch Bi₂Sr₂Ca₁Cu₂O_{z}, ausgedrückte Zusammensetzung aufweist, auf der Oberfläche des Substrates oder des Basiskörpers (3), ein Oxidsupraleiter-Dickfilm (5), welcher im Wesentlichen die durch (Bi,PB)_{Z+a}Sr₂Ca₂Cu₃O_{z} ausgedrückte Zusammensetzung aufweist, die 0<a<0,5 erfüllt, auf dem primären Dickfilm gebildet wird, wobei die Zusammensetzung eines supraleitenden Verbundpulvers, welches in dem für die Bildung des Oxidsupraleiter-Dickfilms verwendeten Beschichtungsmaterial (2) enthalten ist, (Bi,PB)₂₊ₐSr₂Ca₂Cu₃O_{z} ist, welches 0<a<0,5 und 0,35<Pb<0,60 erfüllt, wobei keine Bruchfläche in dem Oxidsupraleiter-Dickfilm in der Nähe der Grenzfläche des Substrates und des Oxidsupraleiter-Dickfilms existiert.

2. Verfahren zur Herstellung eines Supraleiter-Dickfilms zur Herstellung eines Oxidsupraleiter-Dickfilms, welcher Bl, Pb, Sr, Ca und Cu umfasst, auf der Oberfläche eines Substrates oder eines Basiskörpers, wobei, nach dem Bilden eines primären Dickfilms (4), welcher im Wesentlichen die durch Bi₂Sr₂Ca,Cu₂O_{z} ausgedrückte Zusammensetzung aufweist, auf der Oberfläche des Substrates oder Basiskörpers (3), ein Oxidsupraleiter-Dickfilm (5), welcher im Wesentlichen die durch (Bi,PB)₂₊ₐSr₂Ca₂Cu₃O_{z} ausgedrückte Zusammensetzung aufweist, die 0<a<0,5 erfüllt, auf dem primären Dickfilm gebildet wird, **dadurch gekennzeichnet, dass** die Zusammensetzung eines supraleitenden Verbundpulvers, welches in dem für die Bildung des Oxidsupraleiter-Dickfilms verwendeten Beschichtungsmaterial (2) enthalten ist, (Bi,PB)₂₊ₐSr₂Ca₂Cu₃O_{z} ist, welches 0<a<0,5 und 0,35<Pb<0,60 erfüllt.

## Revendications

1. Film épais supraconducteur à oxyde pouvant être obtenu en formant un film épais supraconducteur à oxyde comprenant du Bi, Pb, Sr, Ca et Cu sur la surface d'un substrat ou d'un corps de base, où, après formation d'un film épais primaire (4) ayant sensiblement la composition exprimée par Bi₂Sr₂Ca₁Cu₂O_{z} sur la surface dudit substrat ou corps de base (3), un film épais supraconducteur à oxyde (5) ayant sensiblement la composition exprimée par (Bi,Pb)₂₊ₐSr₂Ca₂Cu₃O_{z} satisfaisant à la relation 0 < a < 0,5 est formé sur ledit film épais primaire, où la formule de composition d'une poudre composite supraconductrice contenue dans le matériau de revêtement (2) utilisé pour la formulation du film épais supraconducteur à oxyde est (Bi,Pb)₂₊ₐSr₂Ca₂Cu₃O_{z} satisfaisant à 0 < a < 0,5 et 0,35 < Pb < 0,60, et où une surface de cassure n'existe pas dans ledit film épais supraconducteur à oxyde prés de l'interface dudit substrat et dudit film épais supraconducteur à oxyde.

2. Procédé de fabrication d'un film épais supraconducteur à oxyde pour former un film épais supraconducteur à oxyde comprenant du Bi, Pb, Sr, Ca et Cu sur la surface d'un substrat ou d'un corps de base, où, après formation d'un film épais primaire (4) ayant sensiblement la composition exprimée par Bi₂Sr₂Ca₁Cu₂O_{z} sur la surface dudit substrat ou corps de base (3), un film épais supraconducteur à oxyde (5) ayant sensiblement la composition exprimée par (Bi, Pb)₂₊ₐSr₂Ca₂Cu₃O_{z} satisfaisant à 0 < a < 0,5 est formé sur ledit film épais primaire, **caractérisé en ce que** la formule de composition d'une poudre composite supraconductrice contenue dans le matériau de revêtement (2) utilisé pour la formulation du film épais supraconducteur à oxyde est (Bi, Pb)₂₊ₐSr₂Ca_{Z}Cu₃O_{z} satisfaisant à 0 < a < 0,5 et 0,35 < Pb < 0,60.
